# FASCICULE DE BREVET EUROPEEN

(11) **EP 2 875 167 B1**
(45) Date de publication et mention de la délivrance du brevet: **06.09.2017**
(21) Numéro de dépôt: 13744739.7
(22) Date de dépôt: 12.07.2013
(51) Int. Cl.: C23C 16/458, C23C 16/46, C23C 16/04, C23C 16/26

(54) **INSTALLATION D'INFILTRATION CHIMIQUE EN PHASE VAPEUR À HAUTE CAPACITÉ DE CHARGEMENT**
CHEMISCHE GASPHASENINFILTRATIONSVORRICHTUNG MIT HOHER BELADUNGSKAPAZITÄT
CHEMICAL VAPOUR INFILTRATION APPARATUS HAVING A HIGH LOADING CAPACITY

(30) Priorité: 19.07.2012 FR 1257012
(43) Date de publication de la demande: 27.05.2015
(73) Titulaire: Safran Ceramics, 33185 Le Haillan (FR)
(72) Inventeur: BERTRAND, Sébastien, F-33480 Moulis en Medoc (FR); LAMOUROUX, Franck, F-33320 Le Taillan Medoc (FR); GOUJARD, Stéphane, F-33700 Merignac (FR); DESCAMPS, Cédric, F-33320 Eysines (FR)
(74) Mandataire: Desormiere, Pierre-Louis
(86) Numéro de dépôt international: PCT/FR2013/051674
(87) Numéro de publication internationale: WO 2014/013168

(56) Documents cités:
- FR-A1- 2 882 064

## Description

### Arrière-plan de l'invention

La présente invention concerne les techniques d'infiltration chimique en phase vapeur utilisées notamment lors de la réalisation de pièces en matériau composite thermostructural. Elle concerne plus particulièrement l'infiltration chimique en phase vapeur de substrats poreux de forme complexe tridimensionnelle tels que des préformes fibreuses destinées à la fabrication d'aubes de moteurs aéronautiques.

Pour la fabrication de pièces en matériau composite, en particulier de pièces en matériau composite thermostructural constituées d'une préforme fibreuse réfractaire (fibres carbone ou céramique, par exemple) densifiée par une matrice réfractaire (carbone et/ou céramique, par exemple), il est courant de faire appel à des procédés d'infiltration. Des exemples de telles pièces sont des tuyères de propulseurs en composite carbone-carbone (C-C), des disques de freins, notamment de freins d'avions, en composites C-C, ou des aubes en composite à matrice céramique (CMC). De même, avant, pendant ou après la densification des préformes, une ou plusieurs couches, par exemple d'interphase, peuvent être déposées dans les préformes en utilisant également la technique d'infiltration chimique en phase vapeur.

L'infiltration chimique en phase vapeur consiste à placer les substrats dans une chambre de réaction d'une installation d'infiltration au moyen d'un outillage de support et à admettre dans la chambre un gaz réactif dont un ou plusieurs constituants sont des précurseurs du matériau à déposer au sein des substrats afin d'assurer leur densification et/ou le dépôt d'une couche par exemple d'interphase. Les conditions d'infiltration, notamment composition et débit du gaz réactif, et température et pression dans la chambre sont choisies pour permettre une diffusion du gaz au sein de la porosité interne accessible des substrats afin qu'y soit déposé le matériau désiré par décomposition d'un constituant du gaz ou réaction entre plusieurs constituants de celui-ci. Le préchauffage du gaz réactif est habituellement réalisé par passage du gaz à travers une zone de préchauffage située dans la chambre de réaction et dans laquelle s'ouvre l'entrée du gaz réactif. Ce procédé correspond au procédé d'infiltration chimique en phase vapeur à flux libre.

Dans une installation industrielle d'infiltration chimique en phase vapeur, il est habituel de charger la chambre de réaction avec plusieurs substrats ou préformes à densifier simultanément pour augmenter le rendement du procédé de densification et, par conséquent, le taux de chargement des chambres de réaction.

Des procédés et installations d'infiltration chimique en phase vapeur de substrats annulaires poreux sont notamment décrits dans les documents US 2004 237898 et US 5 904 957. Cependant, ces procédés s'appliquent essentiellement à l'infiltration de substrats de forme annulaire disposés en piles et ne sont pas adaptés pour l'infiltration de substrats présentant des formes non axisymétriques.

Le document US 2008/0152803 décrit l'utilisation d'un outillage de chargement comprenant un conduit tubulaire disposé entre des premier et second plateaux et autour duquel sont disposés radialement des substrats minces en forme de plaque à densifier. L'outillage ainsi chargé est alors disposé à l'intérieur d'une chambre de réaction d'un four d'infiltration dont l'entrée d'admission en gaz réactif est raccordée au conduit tubulaire pour permettre l'admission d'un gaz réactif dans le conduit qui distribue le gaz le long des faces principales des substrats suivant une direction d'écoulement essentiellement radiale.

Toutefois, cet outillage de chargement reste limité à la densification en flux dirigé de substrats minces de forme simples tels que des fines plaques rectangulaires et ne peut permettre une densification homogène de substrats poreux présentant des formes complexes tridimensionnelles tels que des préformes fibreuses d'aubes. En effet, l'écoulement d'un flux gazeux sur des substrats de forme complexe tridimensionnelle est plus difficile à contrôler. De même, ce type d'outillage entraîne une dispersion thermique qui empêche un contrôle aisé de la température en tout point des préformes et entre les préformes. Le manque de maîtrise de l'écoulement du gaz réactif sur l'ensemble des préformes à infiltrer entraîne l'apparition de gradients de densification ou de dépôt dans les substrats. Or, l'uniformité de la densification ou du dépôt dans un substrat conditionne les performances mécaniques de la pièce obtenue.

En outre, le taux de chargement des installations d'infiltration avec des outillages dans lesquels les préformes à infiltrer sont disposées radialement est relativement faible. Une production à l'échelle industrielle de pièces de forme tridimensionnelle complexe nécessite dans ce cas de fabriquer et d'utiliser un nombre important d'installations d'infiltration, ce qui est très pénalisant sur le plan économique.

### Objet et résumé de l'invention

L'invention a pour but de fournir une solution qui permet d'infiltrer des préformes poreuses, en particulier de forme tridimensionnelle complexe s'étendant principalement dans une direction longitudinale, avec une capacité de chargement élevée, et ce en assurant des dépôts uniformes dans les préformes.

Ce but est atteint avec une installation d'infiltration chimique en phase vapeur de préformes fibreuses de forme tridimensionnelle s'étendant principalement dans une direction longitudinale, l'installation comprenant :
- une chambre de réaction de forme parallélépipédique, les parois latérales de la chambre de réaction comprenant des moyens de chauffage,
- une pluralité de piles de dispositifs de chargement disposées dans la chambre de réaction, chaque dispositif de chargement étant formé d'une enceinte parallélépipédique munie d'éléments de support destinés à recevoir des préformes fibreuses à infiltrer.

Ainsi en utilisant à la fois une chambre de réaction et des piles de dispositifs de chargement de forme parallélépipédique, il est possible d'augmenter très significativement le taux de chargement en préformes de l'installation en comparaison des installations d'infiltration qui utilisent des dispositifs de chargement annulaires. En effet, les dispositifs de chargement présentant un espace de chargement parallélépipédique, les préformes peuvent être disposées parallèlement les unes à côté des autres suivant leur direction longitudinale, ce qui permet d'obtenir un taux d'occupation optimal du volume de chargement de chaque dispositif de chargement. Dans le cas d'un dispositif de chargement annulaire comme dans l'art antérieur, les préformes sont disposées radialement, ce qui ne permet pas une occupation optimale du volume de chargement.

En outre, grâce à leur forme parallélépipédique, les dispositifs de chargement, une fois empilés les uns sur les autres, forment des piles qui permettent de remplir de façon optimale la chambre de réaction également de forme parallélépipédique. En choisissant des dimensions adaptées pour les dispositifs de chargement constituant les piles, il est possible de former un chargement de préformes qui est apte à occuper tout le volume utile de chargement de l'installation d'infiltration.

Chaque dispositif de chargement forme en outre un puits thermique et joue, par conséquent, individuellement le rôle de suscepteur.

Par ailleurs, dans chaque pile, les dispositifs de chargement coopèrent entre eux pour former un volume de chargement qui s'étend suivant une direction verticale dans la chambre de réaction, ce qui permet un écoulement sensiblement rectiligne dans chaque pile et, par conséquent, une meilleure maîtrise de l'écoulement et de l'appauvrissement de la phase gazeuse. Malgré le grand nombre de préformes présentes dans un même chargement selon l'invention, la phase gazeuse traverse seulement un nombre limité de préformes dans chaque pile, ce qui permet d'éviter un appauvrissement trop important de la phase gazeuses lors de son passage à travers les préformes.

Enfin, la température peut être contrôlée de manière plus uniforme dans la chambre de réaction car le chauffage de cette dernière est assuré au moins par les parois latérales de la chambre.

Selon un premier aspect de l'invention, la chambre de réaction présente une forme parallélépipédique rectangle et comprend au moins une rangée d'une pluralité de piles de dispositifs de chargement, ladite rangée s'étendant dans la direction longitudinale de la chambre de réaction. Le chauffage de la chambre de réaction étant assuré notamment par les parois latérales de la chambre de réaction, il n'y a pas de restriction sur la longueur de la chambre et, par conséquent, sur celle du chargement, ce qui permet d'obtenir un taux de chargement très important.

Selon un deuxième aspect de l'invention, chaque dispositif de chargement est formé d'une enceinte parallélépipédique rectangle, les piles étant positionnées dans la chambre de réaction de manière à ce que chaque dispositif de chargement s'étende longitudinalement dans la chambre de réaction dans une direction perpendiculaire à la direction longitudinale de la chambre.

Selon un troisième aspect de l'invention, la chambre de réaction comprend plusieurs rangées de piles de dispositifs de chargement s'étendant dans la direction longitudinale de la chambre de réaction, des moyens de chauffage étant disposés entre deux rangées de piles de dispositifs de chargement. Dans ce cas, la largeur de la chambre de réaction peut être augmentée tout en conservant la maîtrise de la thermique dans cette dimension.

Selon un quatrième aspect de l'invention, chaque pile comprend à chacune de ses extrémités une zone tampon destinée à être dépourvue de substrats poreux à densifier. En sommet de pile, c'est-à-dire à l'endroit de l'introduction de la phase gazeuse, la zone tampon permet notamment d'éviter un impact direct de la phase gazeuse en sortie de zone de préchauffage avec les préformes. A la base de chaque pile, la zone tampon permet de redresser les flux gazeux avant leur évacuation de la chambre de réaction.

Selon un cinquième aspect de l'invention, les parois horizontales de la chambre de réaction comprennent des moyens de chauffage.

Selon un sixième aspect de l'invention, les dispositifs de chargement de chaque pile comprennent des préformes fibreuses d'aube de moteur aéronautique.

Selon un septième aspect de l'invention, les préformes fibreuses d'aubes sont alignées les unes à côté des autres dans chaque dispositif de chargement avec leur face intrados ou extrados orientée suivant une même direction. Dans ce cas, dans chaque pile de dispositifs de chargement, les préformes fibreuses d'un premier dispositif de chargement sont de préférence alignées les unes à côté des autres avec leur face intrados ou extrados orientée suivant une première direction tandis que les préformes fibreuses d'un deuxième dispositif de chargement adjacent audit premier dispositif sont alignées les unes à côté des autres avec leur face intrados ou extrados orientée suivant une deuxième direction opposée à la première direction. Cela permet d'obtenir un meilleur écoulement des flux gazeux au plus près des préformes.

### Brève description des dessins

D'autres caractéristiques et avantages de l'invention ressortiront de la description suivante de modes particuliers de réalisation de l'invention, donnés à titre d'exemples non limitatifs, en référence aux dessins annexés, sur lesquels:
- la figure 1 est une vue en perspective d'un dispositif de chargement avec des préformes d'aubes conformément à un mode de réalisation de l'invention ;
- la figure 2 est une vue éclatée du dispositif de chargement de la figure 1 ;
- la figure 3 est une vue en perspective d'un dispositif de chargement avec des préformes d'aubes conformément à un autre mode de réalisation de l'invention ;
- la figure 4 est une vue en perspective d'une pile constituée d'une pluralité de dispositifs de chargement de la figure 1 empilés les uns sur les autres conformément à un mode de réalisation de l'invention ;
- la figure 5A est une vue en perspective d'un chargement constitué de plusieurs rangées de piles de la figure 4 ;
- la figure 5B est une vue en perspective montrant l'assemblage de zones tampon dans les parties supérieure et inférieure du chargement de la figure 5A ;
- la figure 6 est une vue en perspective éclatée d'une installation d'infiltration chimique en phase vapeur conformément à un mode de réalisation de l'invention ;
- la figure 7 est une vue en coupe montrant la mise en place du chargement de la figure 5B dans l'installation d'infiltration en phase vapeur de la figure 6 ;
- la figure 8 est une vue en coupe montrant le trajet des flux de gaz réactifs lors de la densification de préformes poreuses durant le fonctionnement l'installation de la figure 6 ;
- la figure 9 est une vue en perspective éclatée d'une installation d'infiltration chimique en phase vapeur comprenant une paroi chauffante interposée entre deux rangées de piles de dispositif de chargement conformément à un mode de réalisation de l'invention.

### Description détaillée de mode de réalisation

La présente invention s'applique à l'infiltration chimique en phase vapeur de préformes poreuses. L'infiltration peut être mise en oeuvre notamment pour la densification de préformes et/ou dépôt de couches, comme des couches d'interphase, dans les préformes.

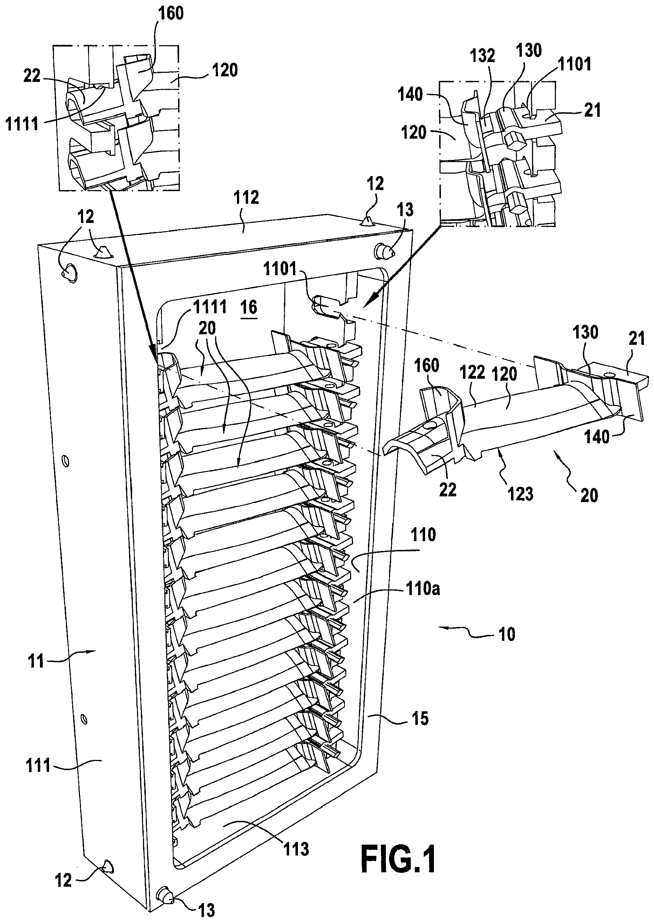

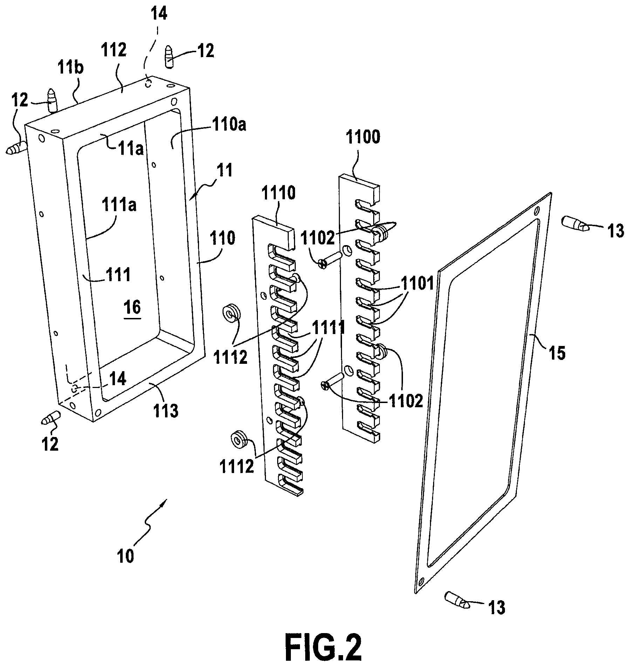

Les figures 1 et 2 représentent un dispositif ou outillage de chargement 10 qui, une fois chargé de substrats à infiltrer, est destiné à être introduit dans une chambre de réaction de forme parallélépipédique d'une installation industrielle d'infiltration chimique en phase vapeur. Dans l'exemple décrit ici, l'outillage 10 est destiné à recevoir des préformes fibreuses d'aube 20 de moteurs aéronautiques.

Chaque préforme 20 s'étend en direction longitudinale entre deux extrémités 21 et 22 et comprend une pale 120 et un pied 130 formé par une partie de plus forte épaisseur, par exemple à section en forme de bulbe, prolongé par une échasse 132 (figure 1). La pale 120 s'étend en direction longitudinale entre son pied 130 et son sommet 121 et présente en section transversale un profil incurvé d'épaisseur variable délimitant deux faces 122 et 123, correspondant respectivement à l'extrados et à l'intrados de la pale 120. Dans l'exemple décrit ici, la pale 120 comprend en outre une plateforme d'aube 140 et un talon d'aube 160.

Le dispositif de chargement 10 décrit ici est formé d'un cadre ou enceinte support 11 de forme parallélépipédique rectangle comprenant deux parois longitudinales 110 et 111 et deux parois transversales 112 et 113, les parois longitudinales 110 et 111 délimitant entre elles un espace de chargement 16 pour les préformes 20. Chaque paroi longitudinale est munie d'éléments de support destinés à recevoir une des extrémités 21 et 22 des préformes d'aube 20. Plus précisément, une première plaque support 1100 comportant des encoches 1101 réparties uniformément sur la longueur de la plaque 1100 est fixée sur la partie interne 110a de la paroi 110 au moyen d'organes de serrage 1102 de type vis/écrou. Les encoches 1101 sont destinées à recevoir les extrémités 21 des préformes 20. De même, une deuxième plaque 1110 comportant des encoches 1111 réparties uniformément sur la longueur de la plaque 1110 est fixée sur la partie interne 111a de la paroi 111 au moyen d'organes de serrage 1112 de type vis/écrou. Les encoches 1111 sont destinées à recevoir les extrémités 22 des préformes 20. Selon une variante de réalisation, les encoches sont directement usinées dans les parois longitudinales du dispositif de chargement.

Une fois positionnées dans le dispositif de chargement 10, les préformes 20 s'étendent longitudinalement entre les parois 110 et 111, ce qui permet d'obtenir un dispositif avec une bonne capacité de chargement. Par ailleurs, l'utilisation de moyens de support au niveau des parois permet de minimiser la surface de contact entre les substrats à densifier et le dispositif de chargement, et d'offrir, en conséquence, une surface accessible optimale pour l'infiltration du gaz réactif.

Dans l'exemple décrit ici, le dispositif de chargement comprend également des pions de centrage 12 disposés sur la partie externe de la paroi longitudinale 111 et de la paroi transversale 112 ainsi que deux pions de détrompage 13 disposés sur la partie supérieure 11a du cadre 11 et deux orifices 14 de détrompage ménagés sur la partie inférieure 11b du cadre 11. Les orifices de détrompage 14 sont destinés à coopérer avec les pions de détrompage d'un autre dispositif de chargement similaire lors de leur empilement. Les orifices de détrompage 14 sont placés à des positions décalées par rapport aux pions de détrompage 13 de manière à permettre une inversion à 180° des préformes 20 d'un dispositif de chargement à l'autre lors de l'empilement de tels dispositifs comme décrit plus en détail ci-après. Le dispositif de chargement comprend en outre un joint en graphite 15 disposé sur la partie supérieure 11a du cadre 11, le joint étant destiné à éviter le collage et faciliter la séparation avec un autre dispositif de chargement empilé après densification des préformes.

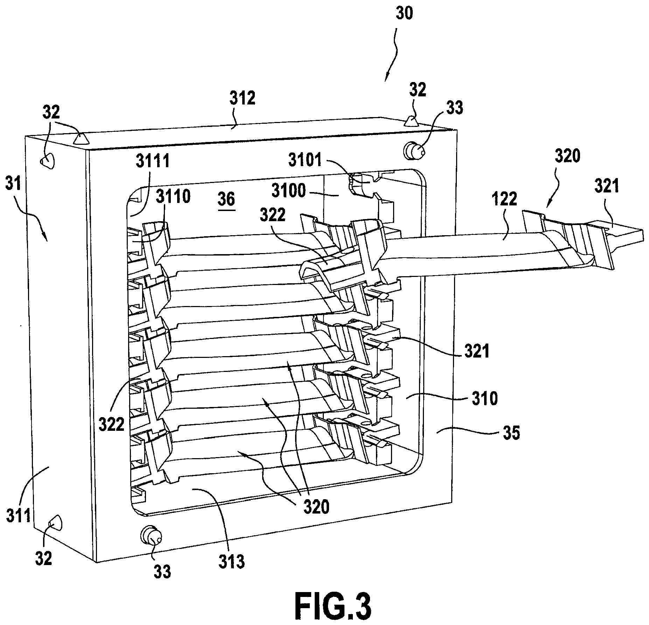

La figure 3 illustre un autre dispositif de chargement 30 selon l'invention qui diffère du dispositif de chargement 10 décrit ci-avant en ce qu'il présente une forme carrée. Le dispositif de chargement 30 comporte cadre ou enceinte support 31 de forme parallélépipédique carrée comprenant quatre parois 310 à 313, les parois longitudinales 310 et 311 délimitant entre elles un espace de chargement 36 pour des préformes d'aube 320 similaires aux préformes d'aube 20 déjà décrites. Une première plaque support 3100 comportant des encoches 3101 réparties uniformément sur la longueur de la plaque 3100 est fixée sur la partie interne de la paroi 310 au moyen d'organes de serrage de type vis/écrou (non représentés sur la figure 3). Les encoches 3101 sont destinées à recevoir les extrémités 321 des préformes 320. De même, une deuxième plaque 3110 comportant des encoches 3111 réparties uniformément sur la longueur de la plaque 3110 est fixée sur la partie interne de la paroi 311 au moyen d'organes de serrage de type vis/écrou (non représentés sur la figure 3). Les encoches 3111 sont destinées à recevoir les extrémités 322 des préformes 320. Selon une variante de réalisation, les encoches sont directement usinées dans les parois 310 et 311 du dispositif de chargement 30.

Une fois positionnées dans le dispositif de chargement 30, les préformes 320 s'étendent longitudinalement entre les parois 310 et 311, ce qui permet d'obtenir un dispositif avec une bonne capacité de chargement. Par ailleurs, l'utilisation de moyens de support au niveau des parois permet de minimiser la surface de contact entre les substrats à densifier et le dispositif de chargement, et d'offrir, en conséquence, une surface accessible optimale pour l'infiltration du gaz réactif.

Dans l'exemple décrit ici, le dispositif de chargement comprend également des pions de centrage 32 disposés sur la partie externe de la paroi longitudinale 311 et de la paroi transversale 312 ainsi que deux pions de détrompage 33 placés sur la partie supérieure du cadre 31 et deux orifices de détrompage (non représentés sur la figure 3) ménagés sur la partie inférieure du cadre 31 destinés à coopérer avec les pions de détrompage d'un autre dispositif de chargement similaire lors de leur empilement. Le dispositif de chargement comprend en outre un joint en graphite 35 disposé sur la partie supérieure 31a du cadre 31 et destiné à éviter le collage et faciliter la séparation avec un autre dispositif de chargement empilé après densification des préformes.

Les joints en graphite décrits précédemment sont de préférence réalisés en graphite expansé comme les matériaux commercialisés sous les marques Sigraflex® ou Papyex®.

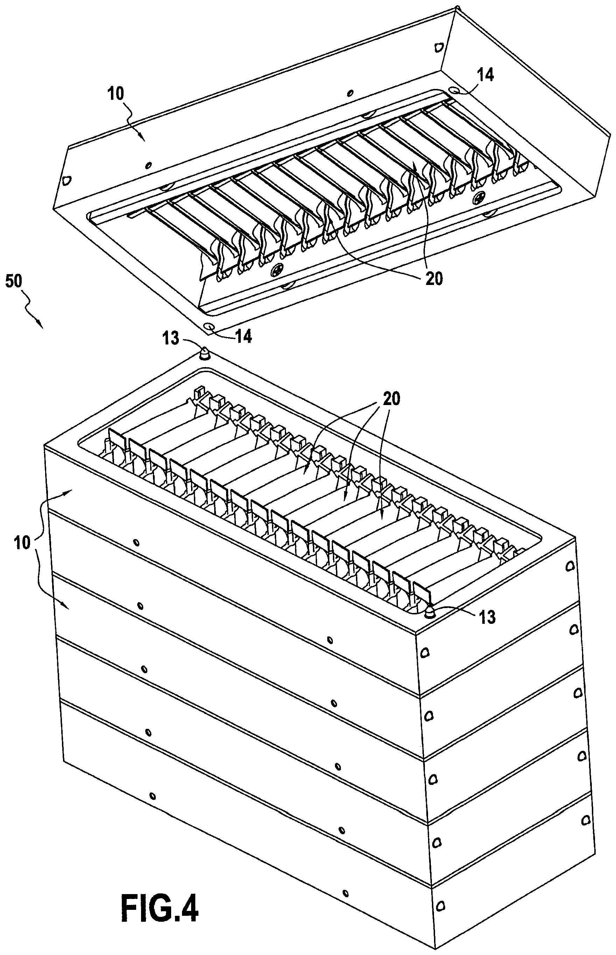

La figure 4 illustre la formation d'une pile 50 à partir d'une pluralité de dispositifs de chargement 10 décrits ci-avant en relation avec les figures 1A et 1B. Comme illustrés sur la figure 4, plusieurs dispositifs de chargement 10, tous identiques et chacun préalablement chargés avec des préformes d'aube 20 à densifier toutes positionnées dans le même sens, sont empilés les uns sur les autres. Lors de l'empilement d'un dispositif de chargement 10 sur un autre déjà présent dans la pile 50, les orifices 14 du dispositif de chargement à empiler coopèrent avec les pions de détrompage 13 du dispositif de chargement déjà présent dans la pile de manière à ce que le dispositif ajouté se trouve décalé de 180° par rapport au dispositif de chargement sous-jacent. Les préformes d'aube ayant toutes été chargées au départ suivant la même orientation dans chacun des dispositifs de chargement, celles-ci se trouvent alors décalées de 180° d'un dispositif de chargement à l'autre dans la pile. Ce décalage angulaire des préformes d'aubes entre deux dispositifs de chargement adjacents dans une pile permet un meilleur écoulement du flux de gaz réactif dans toute la pile. En effet en orientant les faces intrados (ou extrados) des préformes d'aubes alternativement dans un sens et puis dans un autre d'un dispositif de chargement à l'autre dans la pile, on réalise une meilleure répartition de la phase gazeuse entre les préformes sur toute la hauteur de la pile, ce qui permet d'obtenir une densification plus homogène des préformes.

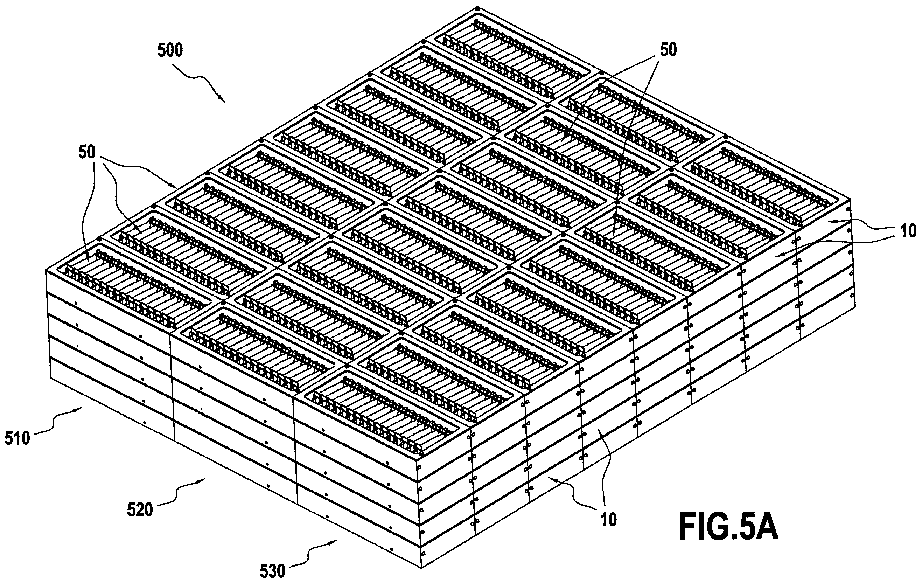

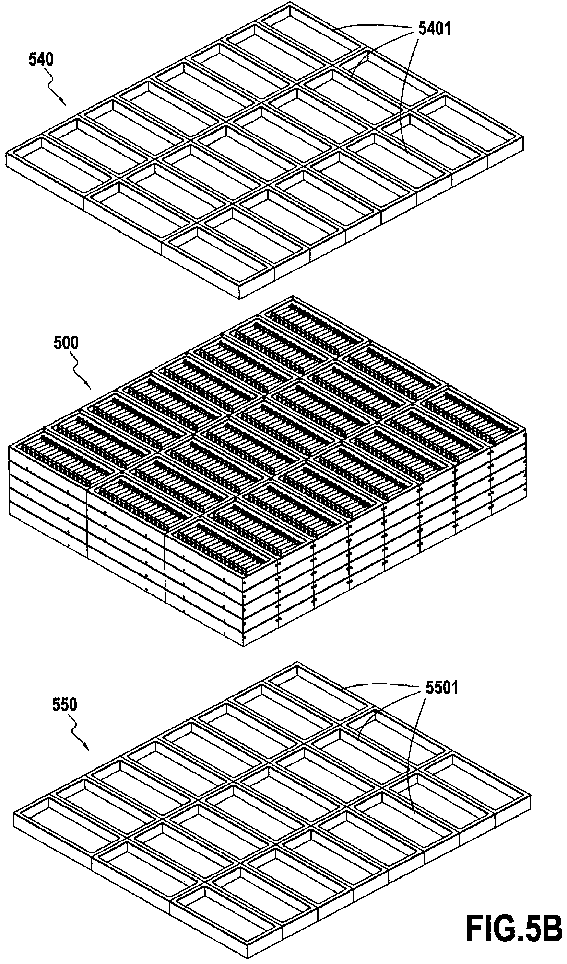

La figure 5A illustre un chargement 500 composé de trois rangées 510, 520 et 530 comprenant chacune une pluralité de piles 50 décrites précédemment en relation avec les figures 1 et 2 s'étendant dans une direction longitudinale D_{L}. Sur la figure 5B, une première zone tampon 540 est disposée sur la partie supérieure du chargement 500 tandis qu'une deuxième zone tampon 550 est disposée sur la partie inférieure du chargement 500. Les zones tampon 540 et 550 sont chacune formées respectivement d'un nombre de cadres ou enceinte parallélépipédiques 5401 et 5501 identiques au nombre de piles 50 présentes dans le chargement 500, les cadres 5401 et 5501 présentant des dimensions identiques à celles des cadres 13 des dispositifs de chargement 10.

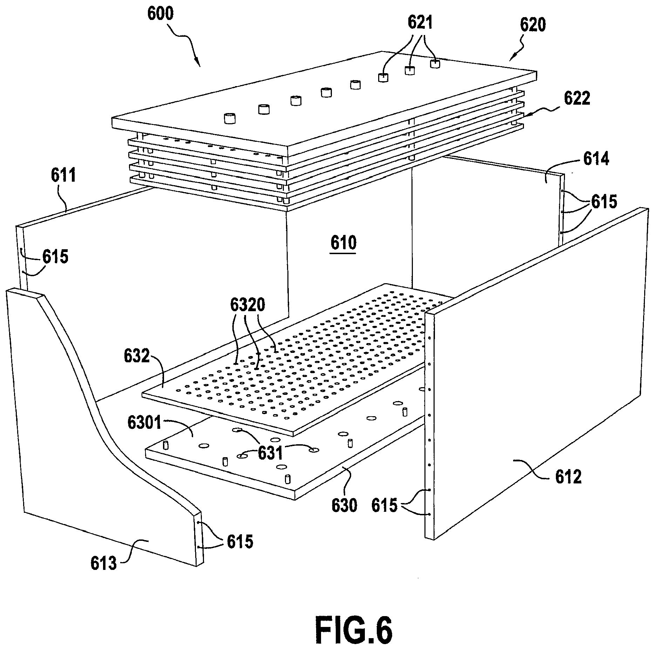

La figure 6 représente schématiquement une installation ou four d'infiltration chimique en phase vapeur 600 destiné à recevoir le chargement 500 comprenant les préformes poreuses à densifier. L'installation d'infiltration chimique en phase vapeur 600 comprend une chambre de réaction parallélépipédique rectangle 610 délimitée par quatre parois latérales 611 à 614, les parois 611 et 612 s'étendant dans la direction longitudinale de la chambre tandis que les parois 613 et 614 s'étendent dans la direction transversale de la chambre. Chacune des parois 611 à 614 est munie de moyens de chauffage, ici des résistances électriques 615 noyées dans chacune des parois 611 à 614. La chambre de réaction est fermée dans sa partie supérieure par un couvercle démontable 620 muni de conduites d'admission de gaz 621 qui débouchent dans une zone de préchauffage 622 permettant de réchauffer le gaz avant sa diffusion dans la chambre de réaction 610 contenant les préformes à densifier. Les gaz résiduels sont extraits au niveau du fond 630 de l'installation par des conduites d'évacuation 631 qui sont reliées à des moyens d'aspiration (non représentés). Le fond 630, qui ferme la chambre de réaction dans sa partie inférieure, comporte une plaque 632 comportant une pluralité d'orifices d'évacuation de gaz 6320 et sur laquelle le chargement 500 est destiné à reposer. Le nombre de conduites d'admission de gaz 621 et de conduites d'évacuation 631 est déterminé en fonction des dimensions de la chambre de réaction à alimenter.

L'espace présent dans la chambre de réaction 610 entre la zone de préchauffage 622 et la plaque 632 correspond au volume de chargement utile de l'installation d'infiltration 600, c'est-à-dire le volume disponible pour charger des préformes fibreuses à infiltrer.

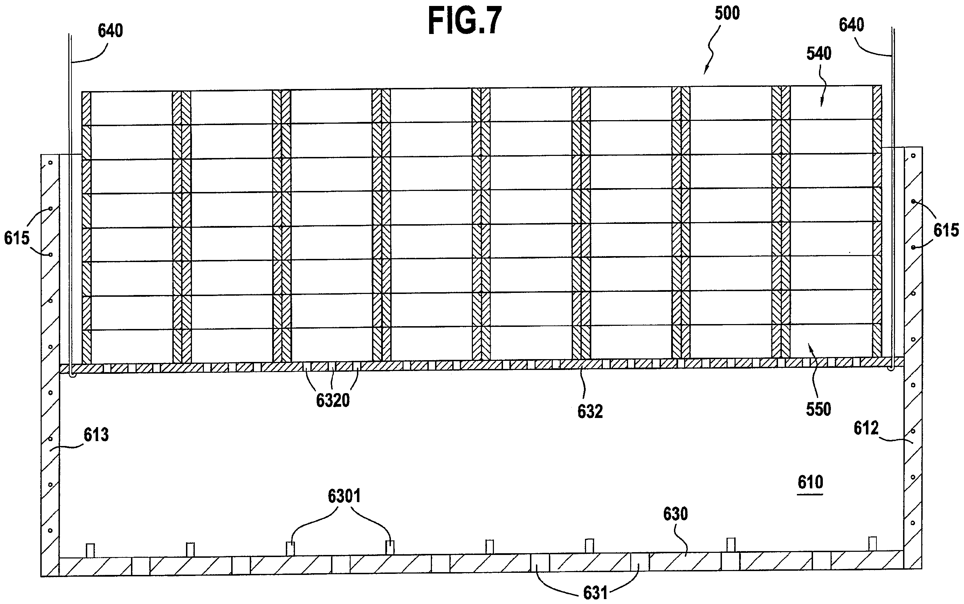

On décrit maintenant la mise en place du chargement 500 comprenant les piles 50 de préformes poreuses 20 dans l'installation d'infiltration chimique en phase vapeur 600. Comme illustré sur la figure 7, le couvercle 620 de l'installation 600 est démonté afin de permettre l'introduction du chargement 500 muni des première et deuxième zones tampon 540 et 550 dans la chambre de réaction 610. Le chargement 500 est descendu dans la chambre 610 au moyen de la plaque 632 et de tirants de manutention 640 jusqu'à ce que la plaque 632 et, par conséquent le chargement 500, reposent sur le support sur le fond 630 via des entretoises 6301.

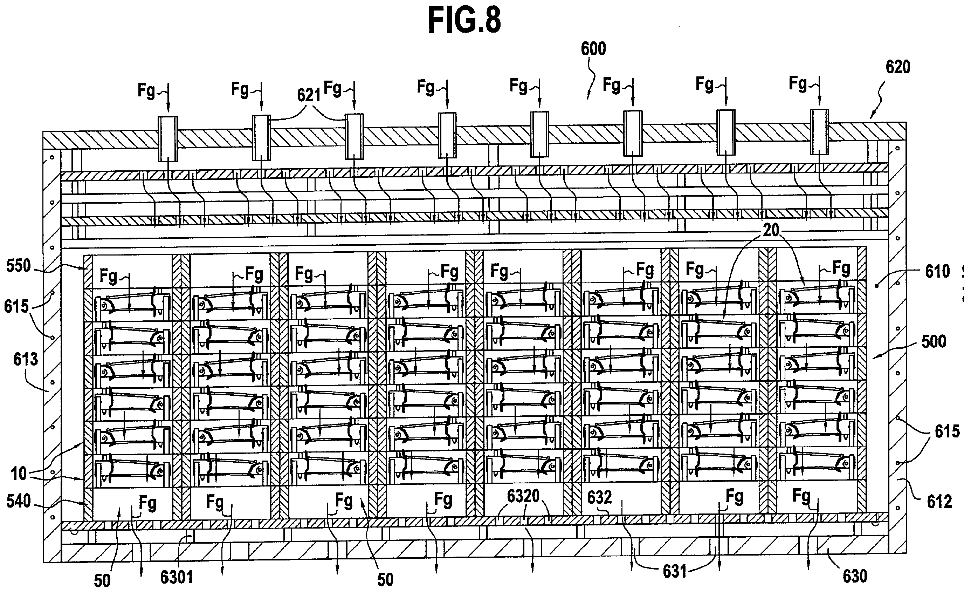

Une fois le chargement 500 positionné dans la chambre de réaction 610, le couvercle 620 est monté sur la partie supérieure de la chambre de réaction comme illustré sur la figure 8. L'installation d'infiltration chimique en phase vapeur est alors prête à fonctionner.

Dans l'exemple décrit ici, l'installation est mise en oeuvre pour densifier les préformes poreuses. Afin d'assurer la densification des préformes, un gaz réactif contenant au moins un ou plusieurs précurseurs du matériau de la matrice à déposer est introduit dans la chambre de réaction 610. Dans le cas du carbone par exemple, on utilise des composés gazeux hydrocarbonés, typiquement du propane, du méthane ou un mélange des deux. Dans le cas d'un matériau céramique, comme du carbure de silicium (SiC) par exemple, on peut utiliser, comme bien connu en soi, du méthyltrichlorosilane (MTS) en tant que précurseur de SiC.

La densification des préformes poreuses est assurée, de façon bien connue en soi, par dépôt au sein de celle-ci du matériau de la matrice produit par décomposition du ou des précurseurs contenus dans le gaz réactif diffusant à l'intérieur de la porosité interne accessible des substrats. Les conditions de pression et de température nécessaires pour obtenir des dépôts de matrices diverses par infiltration chimique en phase vapeur sont bien connues en elles-mêmes.

Chaque dispositif de chargement présent dans la chambre forme un puits thermique. Ainsi, une fois les moyens de chauffage des parois de la chambre de réaction activé, chaque dispositif de chargement joue individuellement le rôle de suscepteur permettant d'élever la température des préformes présentes dans chaque dispositif.

La figure 8 montre le trajet suivi par les flux de gaz réactif Fg introduits dans la chambre de réaction 610 par la conduite d'admission 621. Un gradient de pression est établi entre les conduites d'alimentation 621 et les conduites d'évacuation 631 afin de favoriser le passage des flux de gaz réactif dans les dispositifs de chargement 10 de chaque pile 50. Les flux Fg traversent tout d'abord la zone de préchauffage 622 puis pénètre dans la première zone tampon 540 qui permet d'éviter un impact direct de la phase gazeuse en sortie de zone de préchauffage avec les préformes. Les flux de gaz réactif Fg circulent ensuite dans les dispositifs de chargement 10 de chaque pile 50 depuis le sommet 50a des piles jusqu'à la base 50b de ces dernières où les résidus de flux gazeux n'ayant pas réagi avec les préformes traversent la deuxième zone tampon 550 qui permet de redresser les flux avant leur évacuation, les flux passant ensuite par les orifices d'évacuation 6320 de la plaque 632 de manière à être extraits de la chambre de réaction 610 par les conduites d'évacuation 631.

Le chargement selon l'invention est constitué d'une ou plusieurs piles de dispositifs de chargement de forme parallélépipédique, par exemple rectangle ou carrée, comme décrits ci-avant. Les piles de dispositifs sont organisés en une ou plusieurs rangées

D'une manière générale, la forme et les dimensions des dispositifs de chargement ainsi que leur disposition dans les piles et la ou les rangées de piles constituant le chargement sont choisies de manière à optimiser au mieux le taux de chargement de préformes dans l'installation d'infiltration.

Grâce à l'utilisation combinée d'une installation d'infiltration ayant une chambre de réaction de forme parallélépipédique dont le chauffage est assuré au moins par les parois latérales de la chambre et d'un chargement ayant également une forme parallélépipédique, il est possible de maîtriser la température dans tout le chargement. La largeur de la chambre, et par conséquent celle du volume utile de chargement, sont limités afin de minimiser les gradients de température qui peuvent apparaître entre les parois latérales de la chambre de réaction s'étendant dans la direction longitudinale de la chambre comme les parois 611 et 612. De même, la hauteur du chargement est limitée afin de contrôler l'écoulement et limiter l'appauvrissement de la phase gazeuse dans les piles. En revanche, la longueur de la chambre et, par conséquent, celle du chargement ne sont absolument pas limitées, ce qui permet d'obtenir un taux de chargement très important.

Des exemples de capacités de chargement pour un volume de chargement utile parallélépipédique déterminé sont donnés ci-dessous :
- dans un volume de chargement utile ayant une hauteur de 0,52 m, une largeur de 0,26 m et une longueur de 14,6 m, il est possible grâce à la présente invention de charger 3185 préformes d'aube d'une longueur d'environ 10 cm en utilisant une rangée de 65 piles comprenant chacune 7 dispositifs de chargement de forme parallélépipédique rectangle contenant chacun 7 préformes d'aubes,
- dans un volume de chargement utile ayant une hauteur de 0,74 m, une largeur de 0,34 m et une longueur de 7,2 m, il est possible grâce à la présente invention de charger 3200 préformes d'aube en utilisant une rangée de 32 piles comprenant chacune 10 dispositifs de chargement de forme parallélépipédique rectangle contenant chacun 10 préformes d'aubes,
- dans un volume de chargement utile ayant une hauteur de 0,74 m, une largeur de 1 m et une longueur de 2,5 m, il est possible grâce à la présente invention de charger 3300 préformes d'aube en utilisant 3 rangées de 11 piles comprenant chacune 10 dispositifs de chargement de forme parallélépipédique rectangle contenant chacun 10 préformes d'aubes.

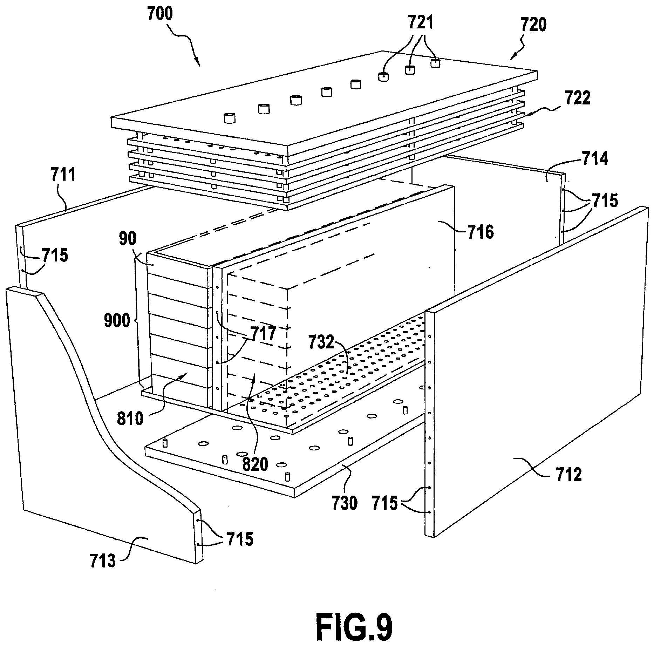

La limitation de la largeur de la chambre de réaction en raison de la maîtrise de l'homogénéité de la température dans cette dimension du volume de chargement utile peut être repoussée en interposant, comme dans l'installation d'infiltration chimique en phase gazeuse 700 illustrée sur la figure 9, une paroi chauffante 716 entre deux rangées 810 et 820 constituées chacune de piles 900 de dispositifs de chargement parallélépipédiques 90 similaires aux dispositifs de chargement 10 déjà décrits. Le chauffage de la paroi 716 est assuré par des moyens de chauffage, ici des résistances électriques 615 noyées dans la paroi 716. Le chauffage du volume de chargement utile de la chambre de réaction 710 est également assuré par les parois latérales 711 à 714 dans lesquelles sont noyées des résistances électriques 715.

Selon une variante de réalisation, des moyens de chauffage, tels que des résistances électriques sont également présents dans la paroi supérieure et/ou la paroi inférieure de la chambre de réaction.

## Revendications

1. Installation d'infiltration chimique en phase vapeur (600) de préformes poreuses (20) de forme tridimensionnelle s'étendant principalement dans une direction longitudinale, l'installation comprenant :
- une chambre de réaction (610) de forme parallélépipédique, les parois latérales (611-614) de la chambre de réaction comprenant des moyens de chauffage (615),
- une pluralité de piles (50) de dispositifs de chargement (10) disposées dans la chambre de réaction (610), chaque dispositif de chargement (10) étant formé d'une enceinte parallélépipédique (11) munie d'éléments de support (1100, 1110) destinés à recevoir des préformes poreuses (20) à infiltrer.

2. Installation selon la revendication 1, **caractérisée en ce que** la chambre de réaction (610) présente une forme parallélépipédique rectangle et **en ce qu'**elle comprend au moins une rangée (510) d'une pluralité de piles (50) de dispositifs de chargement (10), ladite rangée s'étendant dans la direction longitudinale de la chambre de réaction.

3. Installation selon la revendication 2, **caractérisée en ce que** chaque dispositif de chargement (10) est formé d'une enceinte parallélépipédique rectangle (11), les piles (50) étant positionnées dans ladite chambre (610) de manière à ce que chaque dispositif de chargement (10) s'étende longitudinalement dans la chambre de réaction dans une direction perpendiculaire à la direction longitudinale de la chambre.

4. Installation selon la revendication 2 ou 3, **caractérisée en ce que** la chambre de réaction (10) comprend plusieurs rangées (510, 520, 530) de piles (50) de dispositifs de chargement (10) s'étendant dans la direction longitudinale de la chambre de réaction et **en ce que** des moyens de chauffage (717) sont disposés entre deux rangées de piles de dispositifs de chargement.

5. Installation selon l'une quelconque des revendications 1 à 4, **caractérisée** en ce chaque pile (50) comprend à chacune de ses extrémités une zone tampon (540 ; 550) destinée à être dépourvue de substrats poreux à densifier.

6. Installation selon la revendication 5, **caractérisée en ce que** les parois horizontales (620, 630) de la chambre de réaction comprennent des moyens de chauffage.

7. Utilisation d'une installation selon la revendication 6, **caractérisée en ce que** les dispositifs de chargement (10) de chaque pile comprennent des préformes fibreuses (20) d'aube de moteur aéronautique.

8. Utilisation selon la revendication 7, **caractérisée en ce que**, dans chaque dispositif de chargement (10), les préformes fibreuses (20) d'aube sont alignées les unes à côté des autres avec leur face intrados (123) ou extrados (122) orientée suivant une même direction.

9. Utilisation selon la revendication 8, **caractérisée en ce que**, dans chaque pile (50) de dispositifs de chargement (10), les préformes fibreuses (20) d'un premier dispositif de chargement sont alignées les unes à côté des autres avec leur face intrados (123) ou extrados (122) orientée suivant une première direction tandis que les préformes fibreuses (20) d'un deuxième dispositif de chargement (10) adjacent audit premier dispositif sont alignées les unes à côté des autres avec leur face intrados (123) ou extrados (122) orientée suivant une deuxième direction opposée à la première direction.

## Patentansprüche

1. Anlage zur chemischen Infiltration von porösen Vorformen (20) mit dreidimensionaler Form, die sich hauptsächlich in eine Längsrichtung erstrecken, in Dampfphase (600), wobei die Anlage umfasst:
- eine Reaktionskammer (610) von parallelflacher Form, wobei die Seitenwände (611-614) der Reaktionskammer Heizmittel (615) umfassen,
- eine Vielzahl von Stapeln (50) von Ladevorrichtungen (10), die in der Reaktionskammer (610) angeordnet sind, wobei jede Ladevorrichtung (10) von einem parallelflachen Raum (11) gebildet ist, der mit Stützelementen (1100, 1110) versehen ist, die dazu bestimmt sind, zu infiltrierende poröse Vorformen (20) aufzunehmen.

2. Anlage gemäß Anspruch 1, **dadurch gekennzeichnet, dass** die Reaktionskammer (610) eine rechteckige parallelflache Form aufweist, und dass sie mindestens eine Reihe (510) einer Vielzahl von Stapeln (50) von Ladevorrichtungen (10) umfasst, wobei sich die Reihe in Längsrichtung der Reaktionskammer erstreckt.

3. Anlage gemäß Anspruch 2, **dadurch gekennzeichnet, dass** jede Ladevorrichtung (10) von eine rechteckigen parallelflachen Raum (11) gebildet ist, wobei die Stapel (50) in der Kammer (610) angeordnet sind, so dass sich jede Ladevorrichtung (10) längs in der Reaktionskammer in eine Richtung senkrecht auf die Längsrichtung der Kammer erstreckt.

4. Anlage gemäß Anspruch 2 oder 3, **dadurch gekennzeichnet, dass** die Reaktionskammer (10) mehrere Reihen (510, 520, 530) von Stapeln (50) von Ladevorrichtungen (10) umfasst, die sich in Längsrichtung der Reaktionskammer erstrecken, und dass Heizmittel (717) zwischen zwei Reihen von Stapeln von Ladevorrichtungen angeordnet sind.

5. Anlage gemäß einem der Ansprüche 1 bis 4, **dadurch gekennzeichnet, dass** jeder Stapel (50) an jedem seiner Enden eine Pufferzone (540, 550) umfasst, die dazu bestimmt ist, keine zu verdichtenden porösen Substrate zu enthalten.

6. Verwendung gemäß Anspruch 5, **dadurch gekennzeichnet, dass** die horizontalen Wände (620, 630) der Reaktionskammer Heizmittel umfassen.

7. Verwendung einer Anlage gemäß Anspruch 6, **dadurch gekennzeichnet, dass** die Ladevorrichtungen (10) jedes Stapels faserige Schaufelvorformen (20) eines Flugzeugmotors sind.

8. Verwendung gemäß Anspruch 7, **dadurch gekennzeichnet, dass** in jeder Ladevorrichtung (10), die faserigen Schaufelvorformen (20) nebeneinander ausgerichtet sind, wobei ihre Oberseite (123) oder Unterseite (122) in eine selbe Richtung gerichtet sind.

9. Verwendung gemäß Anspruch 8, **dadurch gekennzeichnet, dass** in jedem Stapel (50) von Ladevorrichtungen (10), die faserigen Vorformen (20) einer ersten Ladevorrichtung nebeneinander ausgerichtet sind, wobei ihre Oberseite (123) oder Unterseite (122) in eine selbe Richtung gerichtet sind, während die faserigen Vorformen (20) einer zweiten Ladevorrichtung (10), die an die erste Vorrichtung grenzt, nebeneinander ausgerichtet sind, wobei ihre Oberseite (123) oder Unterseite (122) in eine zweite Richtung, die zur ersten Richtung entgegengesetzt ist, gerichtet sind.

## Claims

1. An installation (600) for chemical vapor infiltration of porous preforms (20) of three-dimensional shape extending mainly in a longitudinal direction, the installation comprising:
• a reaction chamber (610) of parallelepiped shape, the side walls (611-614) of the reaction chamber including heater means (615); and
• a plurality of stacks (50) of loader devices (10) arranged in the reaction chamber (610), each loader device (10) being in the form of an enclosure (11) of parallelepiped shape provided with support elements (1100, 1110) for receiving porous preforms (20) for infiltrating.

2. An installation according to claim 1, **characterized in that** the reaction chamber (610) is of rectangular parallelepiped shape, and **in that** it includes at least one row (510) of a plurality of stacks (50) of loader devices (10), said row extending in the longitudinal direction of the reaction chamber.

3. An installation according to claim 2, **characterized in that** each loader device (10) is formed by an enclosure (11) of rectangular parallelepiped shape, the stacks (50) being positioned in said chamber (610) in such a manner that each loader device (10) extends longitudinally in the reaction chamber in a direction perpendicular to the longitudinal direction of the chamber.

4. An installation according to claim 2 or claim 3, **characterized in that** the reaction chamber (10) has a plurality of rows (510, 520, 530) of stacks (50) of loader devices (10) extending in the longitudinal direction of the reaction chamber, and **in that** heater means (717) are arranged between two rows of stacks of loader devices.

5. An installation according to any one of claims 1 to 4, **characterized in that** each stack (50) includes at each of its ends a respective buffer (540; 550) that is to be empty of porous substrates for densifying.

6. An installation according to claim 5, **characterized in that** the horizontal walls (620, 630) of the reaction chamber include heater means.

7. Use of an installation according to claim 6, **characterized in that** the loader devices (10) of each stack comprise fiber preforms (20) for aeroengine blades

8. Use according to claim 7, **characterized in that** in each loader device (10), the blade fiber preforms (20) are in alignment one beside another having their pressure side faces (123) or suction side faces (122) oriented in a common direction.

9. Use according to claim 8, **characterized in that** in each stack (50) of loader devices (10), the fiber preforms (20) of a first loader device are in alignment one beside another with their pressure side faces (123) or their suction side faces (122) oriented in a first direction, while the fiber preforms (20) of a second loader device (10) adjacent to said first device are in alignment one beside another with their pressure side faces (123) or suction side faces (122) oriented in a second direction opposite to the first direction.
